Europäisches Patentamt

**European Patent Office**

Office européen des brevets

Publication number: **0 276 052**
**A2**

# EUROPEAN PATENT APPLICATION

Application number: **88300069.7**

Date of filing: **06.01.88**

Int. Cl.⁴: **H 01 R 23/68**

Priority: **15.01.87 US 3495**

Date of publication of application:
**27.07.88 Bulletin 88/30**

Designated Contracting States: **DE FR GB**

Applicant: **ETA SYSTEMS, INC.**
**1450 Energy Park Drive**
**St. Paul, MN 55108 (US)**

Inventor: **Hoelzel, Roy John**
**10707 Madison Street, NE.**
**Minneapolis Minnesota 55434 (US)**

**Doyle, Brent Henry**
**921 Overton Drive**
**Minneapolis Minnesota 55432 (US)**

Representative: **Caro, William Egerton et al**
**J. MILLER & CO. Lincoln House 296-302 High Holborn**
**London WC1V 7JH (GB)**

## Memory system assembly.

A memory system assembly comprises an input interconnection network substrate having a system input electrical connector pair first member affixed at a first edge portion thereof which can be selectively mated with a system input electrical connector pair second member for connection to external electrical apparatus to pass electrical signals therebetween, said input substrate first edge portion being located between input substrate second and third edge portions with said input substrate second edge portion having a first internal electrical connector pair first member affixed thereto and with said input substrate third edge portion having a second internal electrical connector pair first member affixed thereto, there being electrical interconnection provided between each of said first and second internal electrical connector pair first members and said system input electrical connector first pair member; an output interconnection network substrate having a system output electrical connector pair first member affixed at a first edge portion thereof which can be selectively mated with a system output electrical connector pair second member for connection to external electrical apparatus to pass electrical signals therebetween, said output substrate first edge portion being located between output substrate second and third edge portions with said output substrate second edge portion having a third internal electrical connector pair first member affixed thereto and with said output substrate third edge portion having a fourth internal connector pair first member affixed thereto, there being electrical interconnections provided between each said third and fourth internal electrical connector pair first members and said system output electrical connector first member; a first transmission interconnection network substrate having selected internal electrical connector pair second members affixed thereto including first and third internal electrical connector pair second members capable of being mechanically and electrically connected with said first and third internal electrical pair first members, respectively, there being electrical interconnections selectively provided between said plurality of internal electrical connector pair second members, said first and third internal electrical connector pair first members being mechanically and electrically connected with said first and third internal electrical connector pair second members, respectively; a second transmission interconnection network substrate having selected internal electrical connector pair second members affixed thereto including second and fourth internal electrical connector pair second members capable of being mechanically and electrically connected with said second and fourth internal electrical pair first members, respectively, there being electrical interconnection selectively provided between said plurality of internal electrical connector pair second members, said second and fourth internal electrical connector pair first members being mechanically and electrically connected with said second and fourth internal electrical connector pair second members, respectively; and a plurality of memory module interconnection network substrates each having a pair of internal electrical connector pair first members affixed at selected edges thereof one of which is capable of being, and is, mechanically and electrically connected with at least one of said selected internal electrical connector pair second members affixed to said first transmission interconnection network substrate and that one remaining capable of being, and is, mechanically and electrically connected with at least one of said selected internal electrical connector pair second members affixed to said second transmission interconnection network substrate, each of said plurality of memory module interconnection network substrates having at least one electronic memory circuit means affixed thereto with each said electronic memory circuit means having an electrical interconnection to each of said internal electrical connector pair first members affixed thereto, said connections of said internal electrical connector pair first and second members being solely relied upon to mechanically connect, in that manner aforesaid, said input, output, first transmission, second transmission and plurality of memory module interconnect network substrates.

Fig.1

**Description**

## MEMORY SYSTEM ASSEMBLY

This invention relates to memory system assemblies.

The criteria for digital memories continues to be the density of information storage, the rapidity possible in acquiring the information stored or in changing that information, and the cost of the digital memory. These criteria are used not only with respect to monolithic integrated circuit memory chips, which are the basis currently on which digital memories are made, but also to the assemblies of substrates on which such integrated circuit memory chips are mounted. These substrates provide electrical interconnections between such chips and to whatever external electronic apparatus is making use of such digital memories. That is, the assemblies of these substrates must also be dense, operate rapidly and must achieve these goals economically.

Indeed, improvements in monolithic integrated circuits in achieving these goals with respect to them leads to greater demands on the digital memory substrates. Integrated circuits, in achieving greater density at higher speed, also tend to increase the power dissipation in each. This increasing heat must be removed from the digital memory, and doing so becomes an even greater burden as the heat density increases because of further compacting of the memory. Furthermore, increases in operating rapidity of the integrated circuits, and increases in the necessary interconnections made thereto because of increased circuit density therein, in turn lead to significant increases in the performance required of the interconnections in the digital memory substrates if the improvements in the integrated circuits are not to be lost. In general, this means that the circuit paths in a digital memory assembly are to be kept as short as possible, with the circuit impedances thereof carefully managed.

To achieve these goals, a desirable digital circuit memory substrate assembly would require no additional parts in its construction other than the basic integrated circuits, and the mounting substrates and interconnections which must be provided therefor, thereby to reduce the costs of assembly and to provide for a compact assembly. Further, such a digital circuit memory should accommodate a compact but effective cooling means to manage the heat dissipation in such a dense assembly.

According to one aspect of the present invention there is provided a memory system assembly characterised by comprising: an input interconnection network substrate having a system input electrical connector pair first member affixed at a first edge portion thereof which can be selectively mated with a system input electrical connector pair second member for connection to external electrical apparatus to pass electrical signals therebetween, said input substrate first edge portion being located between input substrate second and third edge portions with said input substrate second edge portion having a first internal electrical connector pair first member affixed thereto and with said input substrate third edge portion having a second internal electrical connector pair first member affixed thereto, there being electrical interconnection provided between each of said first and second internal electrical connector pair first members and said system input electrical connector first pair member; an output interconnection network substrate having a system output electrical connector pair first member affixed at a first edge portion thereof which can be selectively mated with a system output electrical connector pair second member for connection to external electrical apparatus to pass electrical signals therebetween, said output substrate first edge portion being located between output substrate second and third edge portions with said output substrate second edge portion having a third internal electrical connector pair first member affixed thereto and with said output substrate third edge portion having a fourth internal connector pair first member affixed thereto, there being electrical interconnections provided between each said third and fourth internal electrical connector pair first members and said system output electrical connector first member; a first transmission interconnection network substrate having selected internal electrical connector pair second members affixed thereto including first and third internal electrical connector pair second members capable of being mechanically and electrically connected with said first and third internal electrical pair first members, respectively, there being electrical interconnections selectively provided between said plurality of internal electrical connector pair second members, said first and third internal electrical connector pair first members being mechanically and electrically connected with said first and third internal electrical connector pair second members, respectively; a second transmission interconnection network substrate having selected internal electrical connector pair second members affixed thereto including second and fourth internal electrical connector pair second members capable of being mechanically and electrically connected with said second and fourth internal electrical pair first members, respectively, there being electrical interconnection selectively provided between said plurality of internal electrical connector pair second members, said second and fourth internal electrical connector pair first members being mechanically and electrically connected with said second and fourth internal electrical connector pair second members, respectively; and a plurality of memory module interconnection network substrates each having a pair of internal electrical connector pair first members affixed at selected edges thereof one of which is capable of being, and is, mechanically and electrically connected with at least one of said selected internal electrical connector pair second members affixed to said first transmission interconnection network substrate and that one remaining capable of being, and is, mechanically and electrically connected with at least one of said selected internal electrical connector pair second members affixed to said second transmission interconnection network substrate, each of said plurality of memory module interconnection network substrates having at least one electronic memory circuit means affixed thereto with each said electronic memory circuit means having an electrical interconnection to each of said internal electrical connector pair first members affixed thereto, said connections of said internal electrical connector pair first and second members being solely relied upon to mechanically connect, in that manner aforesaid, said input, output, first transmission, second transmission and plurality of memory module interconnect network substrates.

According to another aspect of the present invention there is provided a memory system assembly characterised by comprising: an input interconnection network substrate having a system input electrical connector pair first member affixed at a first edge portion thereof which can be selectively mated with a system input electrical connector pair second member for connection to external electrical apparatus to pass electrical signals therebetween, said input substrate first edge portion being located between input substrate second and third edge portions with said input substrate second edge portion having a first internal electrical connector pair first member affixed thereto and with said input substrate third edge portion having a second internal electrical connector pair first member affixed thereto, there being electrical interconnection provided between each of said first and second internal electrical connector pair first members and said system input electrical connector first pair member; an output interconnection network substrate having a system output electrical connector pair first member affixed at a first edge portion thereof which can be selectively mated with a system output electrical connector pair second member for connection to external electrical apparatus to pass electrical signals therebetween, said output substrate first edge portion being located between output substrate second and third edge portions with said output substrate second edge portion having a third internal electrical connector pair first member affixed thereto and with said output substrate third edge portion having a fourth internal connector pair first member affixed thereto, there being electrical interconnections provided between each said third and fourth internal electrical connector pair first members and said system output electrical connector first member; a first transmission interconnection network substrate having selected internal electrical connector pair second members affixed thereto including first and third internal electrical connector pair second members capable of being mechanically and electrically connected with said first and third internal electrical pair first members, respectively, there being electrical interconnections selectively provided between said plurality of internal electrical connector pair second members, said first and third internal electrical connector pair first members being mechanically and electrically connected with said first and third internal electrical connector pair second members, respectively; a second transmission interconnection network substrate having selected internal electrical connector pair second members affixed thereto including second and fourth internal electrical connector pair second members capable of being mechanically and electrically connected with said second and fourth internal electrical pair first members, respectively, there being electrical interconnection selectively provided between said plurality of internal electrical connector pair second members, said second and fourth internal electrical connector pair first members being mechanically and electrically connected with said second and fourth internal electrical connector pair second members, respectively; and a plurality of memory module interconnection network substrates each having a pair of internal electrical connector pair first members affixed at selected edges thereof one of which is capable of being, and is, mechanically and electrically connected with at least one of said selected internal electrical connector pair second members affixed to said first transmission interconnection network substrate and that one remaining capable of being, and is, mechanically and electrically connected with at least one of said selected internal electrical connector pair second members affixed to said second transmission interconnection network substrate, each of said plurality of memory module interconnection network substrates having at least one electronic memory circuit means affixed thereto with each said electronic memory circuit means having an electrical interconnection to each of said internal electrical connector pair first members affixed thereto; and a cooling insert means positioned in at least some of those spaces occurring between members of said plurality of memory module interconnection network substrates and between members of said plurality of memory module interconnection network substrates and said input and output interconnection network substrates, and having substantially enclosed gas chambers located therein with openings in said gas chambers opposite said electronic memory circuit means so that when a pressurised gas is supplied to said gas chambers that gas escaping from said openings therein will impinge on said electronic memory circuit means.

The invention is illustrated, merely by way of example, in the accompanying drawings, in which:-

    Figure 1 is an exploded view of a memory system assembly according to the present invention;

    Figure 2 shows a portion of the memory system assembly of Figure 1;

    Figure 3 shows another portion of the memory system assembly of Figure 1; and

    Figure 4 is a cross-section taken along the line 4-4 of Figure 1.

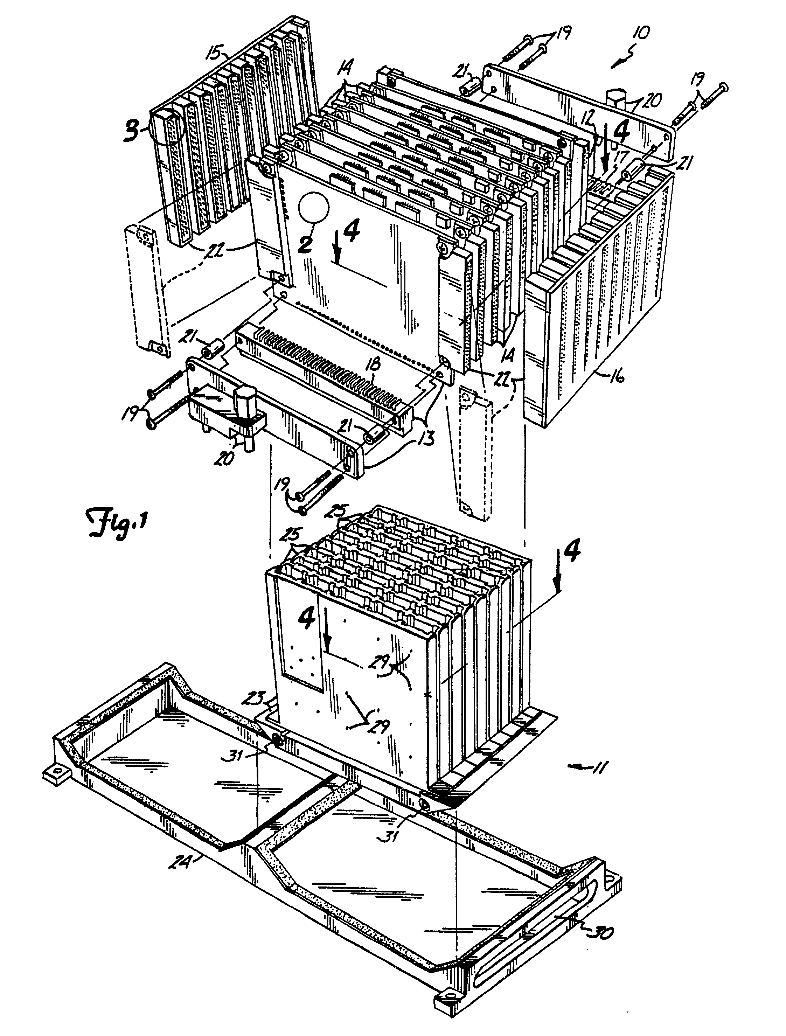

Figure 1 shows a memory system assembly 10 according to the present invention, with a multiple chamber cooling insert 11. A digital memory of the memory system assembly is, in common engineering terms, a 512K word memory by 39 bits (actually a 524,288 word memory) capable of having information placed therein and information acquired therefrom in times ranging from 5 to 20 nanoseconds at typical operating voltages of around 5 volts.

The memory system assembly 10 is approximately 10cm (4in) wide by just over 9cm (3.5in) deep and just over 10cm (4in) high. Within this small volume, cooling must be provided because the assembly 10 may draw from 12 to 18 amps at the above described information transfer rates. Such cooling is provided by using the cooling insert 11 to distribute chilled air, typically 0°C, provided under pressure.

The memory system assembly 10 comprises one input interconnection network substrate 12 and associated connectors (or input board or card), one output interconnection network substrate 13 and associated connectors (or output board or card), and eight memory module interconnection network substrates 14 (or memory boards or cards), all parallel to one another as shown in Figure 1. In addition, each of the foregoing substrates, on its left hand side in Figure 1, is connected into a first transmission interconnection network substrate 15 (or write or input board or card). This same set of parallel substrates, each on the right hand side thereof, is connected into a second transmission interconnection network substrate 16 (or read or output card or board).

External signals from external apparatus (not shown) using the memory system assembly 10 are provided via a 96 pin connector 17 which is affixed to and is part of the input substrate 12. Signals provided by the digital memory to such apparatus, on the other hand, are made available at another 96 pin connector 18 affixed to and part of the output substrate 13. These connectors are so affixed by threaded fasteners 19 which also affix a pair of digital memory assembly fasteners 20 to the input and output substrates 12,13. Note that there is an indexing pin in the fasteners 20 with a different spacing for the input substrate 12 and for the output substrate 13 so that the memory system assembly 10 cannot be interchanged end-for-end. Some of the fasteners 19 go through spacers 21 to provide the fasteners 20 with a standoff over the corresponding connectors 17,18.

The input signals entering the memory system assembly 10 through the connector 17 involve 39 data lines, 18 address lines and various operation control lines. Signal interconnections leading from the connector 17 to remaining parts of the input substrates 12 all have the transmission line impedance thereof carefully chosen to meet transmission needs insofar as effects on signal transmission thereover is concerned. Certain tuning jumpers are used thereon to adjust accurately delays in the clock signal paths to provide accurate timing signals in the digital memory.

The input substrate 12 is a multiple tier interconnection board, that is, the input substrate 12 has multiple metallic interconnection levels each separated from each adjacent one by a dielectric material layer except at feedthroughs. Such metallic feedthroughs interconnect the interconnection levels by passing through dielectrics. The input substrate 12 has eight levels of interconnections separated by seven dielectric layers.

The input signals coming from the connector 17 are routed to various monolithic integrated circuits serving variously as resistors, buffers and decision logic modules, on the input substrate 12. These integrated circuits are complementary silicon gate, metal-oxide-semiconductor (MOS) field-effect transistor (FET) based circuits. Signals generated in these integrated circuits then leave the input substrate 12 for other destinations in the digital memory. The data and address lines leave the registers in the integrated circuits on the input substrate 12 through an electrical internal connector 22, having its first member affixed to the input substrate 12 by threaded fasteners clamping this first member against surface interconnections. A corresponding second member, which together with the first member form the connector 22, is affixed to the substrate 15. This connector 22 is a 101 pin connector. Certain of the control signals are also carried through this connector. Another connector 22 of the same general type is provided on the opposite edge of the input substrate 12, this connector having its first member affixed to the input substrate 12 and its second member affixed to the substrate 16. Certain control signals also leave the input substrate 12 through the second connector for the substrate 16.

The substrate 15 contains a memory write data bus and address bus interconnections which are connected to all eight of the substrates 14. These control signals from the input substrate 12 which are provided to the substrate 15 are carried also by the substrate 15 to selected ones of the substrates 14.

The substrate 15 has ten levels of metallic interconnections separated by nine dielectric material layers. The transmission line impedances of these are again carefully arranged to avoid or minimise unwanted signal effects. Metallic feedthroughs between various levels of these interconnections interconnect them. The second members of the connector 22, one for each substrate 14 and for the input substrate 12 and the output substrate 13, are affixed to the substrate 15 and clamped against a surface level of interconnections.

The substrate 16 has on it memory read data bus interconnections which are all connected to all of the substrates 14. Certain control signals are also carried by the interconnections on the substrate 16 to selected substrates 14, as are certain clock signals. A clock signal is also transmitted by the substrate 16 to the output substrate 13.

The substrate 16 has eight levels of metallic interconnections separated by seven dielectric material layers. Metallic feedthroughs are provided here also between various interconnection levels. Once again, associated transmission line impedances are all carefully chosen to avoid or minimise unwanted signal effects. The second members of the connector 22, again one for each substrate 14 and for the input substrate 12 and the output substrate 13, are clamped against a surface level of interconnections on the substrate 16.

Each substrate 14 has six levels of metallic interconnections separated by five dielectric material layers. Again, there are metallic feedthroughs, conductors extending through the dielectrics, to interconnect the various interconnection levels. Each of the substrates 14 also has a first member of a connector 22 on each side thereof. Each of these connectors fits into a corresponding mating second connector, one on each of the substrate 15 and the substrate 16.

Each substrate 14 has CMOS integrated circuits on it forming static random access memory chips providing together storage in common engineering terms of 64K words (actually 65,536 words) of 39 bits each. All of the data and address inputs to each substrate 14 is clocked into integrated circuits serving as registers to receive such inputs. Data leaving the substrate 14 is also first stored in buffer registers from which it can be switched into the read data bus. Various control and clock signals transmitted from the substrates 15,16 control these operations in the substrate 14.

The output substrate 13 receives the read data bus and stores data on it in registers formed in CMOS integrated circuits thereon. The output substrate 13 has eight levels of metallic interconnections separated by seven dielectric material layers with appropriate metallic feedthroughs to interconnect with various interconnection levels. Again, the impedance of the various interconnection lines is carefully managed as are the delays in the clock signal interconnection lines. The first members of the connector 22 are clamped at either side against a surface interconnection level for mating with corresponding second members on the substrates 15,16.

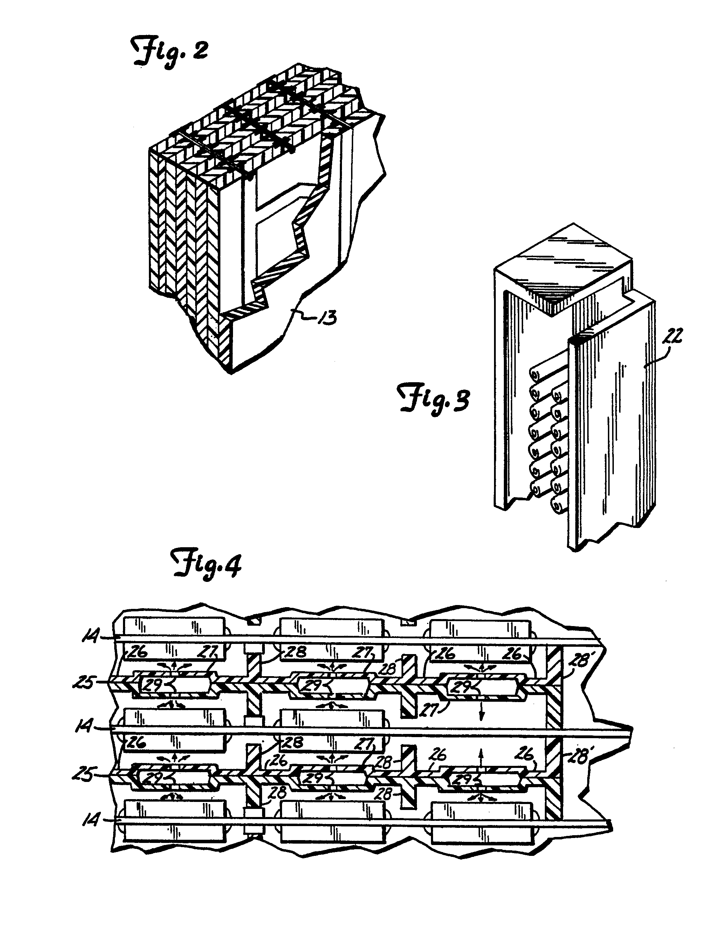

Figure 2 shows a breakout of the output of substrate 13. There can be seen the dielectric layers separating the metallic interconnection levels and a feedthrough between the surface interconnection layer and the first interconnection layer therebelow. These various dielectric layers and interconnection layers all adhere to one another in the order shown in Figure 2 thereby to provide a single output substrate, multiple interconnection level structure. The structures of the input substrate 12, substrates 14, substrate 15 and the substrate 16 are similar, even though there may be differences in numbers of interconnection levels and dielectric layers.

The connectors 22 are formed with the second members being female portions thereof and mounted on the substrates 15,16. The first members of the connector 22 are then, of course, male portions of the connectors and mount on the input substrate 12, the output substrate 13 and the substrates 14, as indicated above. A breakout of a portion of a second member of the connector 22 mounted on the substrate 15 is shown in Figure 3. There can be seen the sockets of the second member of the connector which sockets are closely fitted with the corresponding pins in the male first member.

These pins have significant lengths and, inserted into the corresponding sockets, 1end substantial rigidity to the mechanical connections made by the connectors 22. As a result, the memory system assembly 10 is held together with nothing more than mating of the first members with the second members of the connectors 22. That is, for purposes of handling, of testing, and of insertion of the memory system assembly into higher assemblies in external apparatus, no other support is provided for holding the various substrates described together as a single unit. Therefore, there is no space taken by extra mechanical support frameworks or fasteners thereby to improve compactness of the memory system assembly, and there is no extra cost in assembling such extras. Once the substrates are assembled to the mating portions of the connectors 22, no further assembly effort is required.

The substantial memory capacity provided in the memory system assembly 10 in the small volume described above leads to a substantial amount of heat being generated in this relatively small volume. Thus, the cooling insert 11 is used to distribute chilled air into the spaces between the substrates 14, and the spaces between the substrates 14 and the input and output substrates 12,13, there to impinge directly on the monolithic integrated circuit as affixed to each of the substrates.

As shown in Figure 1, the cooling insert 11 comprises an insert portion 23, and a base interface portion 24. The insert portion 23 comprises a series of enclosed chamber structures 25. Each of these chamber structures is further subdivided into enclosed chambers by a number of vertical stiffening supports between each enclosed chamber. In addition, the stiffening supports have linear protrusions therealong projecting outward from surfaces of the chamber structures 25. The insert portion 23 with the chamber structures 25 is, in use, inserted in the spaces between the substrates 14 and between the substrates 14 and the input substrate 12 and the output substrate 13.

The integrated circuits affixed to these boards are provided in vertical columns on these boards to fit between pairs of linear protrusions. Each chamber structure has a hole therein directly across from each of those monolithic integrated circuits in the corresponding column thereof so that chilled air brought to a common chamber beneath the insert portion 23 can travel through the various chamber structures and out of the holes to impinge directly on such monolithic integrated circuits.

Figure 4 better shows this relationship between the insert portion 23 and the memory system assembly 10. As can be seen, the substrate 14 having integrated circuits positioned on either side thereof are shown as examples with the chamber structures 25 provided in the spaces between the substrates 14 and between the integrated circuits also in that space between the substrates 14. There can be further seen support structures 26 separating individual gas chamber enclosures 27. Linear protrusions 28 extend outward from the surface of the support structure 26. In some instances, the protrusions 28 are directly against components on the substrates 14 and, in any event, assure that there will be adequate separation between these substrates at all times. End linear protrusions 28' give additional such assurance in actually being against the substrates 14 and the input and output substrates 12,13. As can be further seen, holes 29 in the gas chamber enclosures 27 permit air under pressure to impinge directly on the monolithic integrated circuits across from such holes.

The insert portion 23, with the memory system assembly 10 affixed thereto, fits against a base interface portion 24, as can be seen in Figure 1. The base interface portion 24 provides additional volume for a common chamber beneath the insert portion 23. Chilled air is forced into the common chamber through an opening 30 in the base of the interface portion 24. The base interface portion 24 can accommodate a second memory system assembly 10 and an insert portion 23, as can be seen in Figure 1. If yet another pair of memory system assemblies is desired, these can be placed over insert portions in an adjacent base interface portion to the right of the one shown in Figure 1. That adjacent base interface portion, however, would have a hole like the hole 30 at both ends thereof to permit air under pressure not only reach this adjacent base interface portion but also the base interface portion 24.

The insert portion 23 has the memory system assembly 10 affixed to it by the lower ones of the threaded fasteners 19 in Figure 1, each being screwed onto a threaded insert 31 in the insert portion 23. The connectors 17,18 fit over the sides of the base interface portion 24 to mate with connectors positioned along the sides in that external apparatus making use of the memory system assembly. The fasteners 20 can be used to fasten the memory system assembly 10 and the cooling insert 11 to such external apparatus.

Clearly, the number of substrates 14 provided in the memory system assembly 10 may be increased or decreased from the eight shown in Figure 1.

## Claims

1. A memory system assembly characterised by comprising: an input interconnection network substrate (12) having a system input electrical connector pair first member affixed at a first edge portion thereof which can be selectively mated with a system input electrical connector pair second member for connection to external electrical apparatus to pass electrical signals therebetween, said input substrate first edge portion being located between input substrate second and third edge portions with said input substrate second edge portion having a first internal electrical connector pair first member affixed thereto and with said input substrate third edge portion having a second internal electrical connector pair first member affixed thereto, there being electrical interconnection provided between each of said first and second internal electrical connector pair first members and said system input electrical connector first pair member; an output interconnection network substrate (13) having a system output electrical connector pair first member affixed at a first edge portion thereof which can be selectively mated with a system output electrical connector pair second member for connection to external electrical apparatus to pass electrical signals therebetween, said output substrate first edge portion being located between output substrate second and third edge portions with said output substrate second edge portion having a third internal electrical connector pair first member affixed thereto and with said output substrate third edge portion having a fourth internal connector pair first member affixed thereto, there being electrical interconnections provided between each said third and fourth internal electrical connector pair first members and said system output electrical connector first member; a first transmission interconnection network substrate (15) having selected internal electrical connector pair second members affixed thereto including first and third internal electrical connector pair second members capable of being mechanically and electrically connected with said first and third internal electrical pair first members, respectively, there being electrical interconnections selectively provided between said plurality of internal electrical connector pair second members, said first and third internal electrical connector pair first members being mechanically and electrically connected with said first and third internal electrical connector pair second members, respectively; a second transmission interconnection network substrate (16) having selected internal electrical connector pair second members affixed thereto including second and fourth internal electrical connector pair second members capable of being mechanically and electrically connected with said second and fourth internal electrical pair first members, respectively, there being electrical interconnection selectively provided between said plurality of internal electrical connector pair second members, said second and fourth internal electrical connector pair first members being mechanically and electrically connected with said second and fourth internal electrical connector pair second members, respectively; and a plurality of memory module interconnection network substrates (14) each having a pair of internal electrical connector pair first members affixed at selected edges thereof one of which is capable of being, and is, mechanically and electrically connected with at least one of said selected internal electrical connector pair second members affixed to said first transmission interconnection network substrate (15) and that one remaining capable of being, and is, mechanically and electrically connected with at least one of said selected internal electrical connector pair second members affixed to said second transmission interconnection network substrate (16), each of said plurality of memory module interconnection network substrates (14) having at least one electronic memory circuit means affixed thereto with each said electronic memory circuit means having an electrical interconnection to each of said internal electrical connector pair first members affixed thereto, said connections of said internal electrical connector pair first and second members being solely relied upon to mechanically connect, in that manner aforesaid, said input, output, first transmission, second transmission and plurality of memory module interconnect network substrates (12-16).

2. Apparatus as claimed in claim 1 characterised in that at least some of those spaces occurring between members of said plurality of memory module interconnection network substrates (14) and between members of said plurality of memory module interconnection network substrates and said input and output interconnection network substrates (12,13) have substantially enclosed gas chambers (27) located therein with openings (29) in said gas chambers opposite said electronic memory circuit means so that when a pressurised gas is supplied to said gas chambers that gas escaping from said openings therein will impinge on said electronic memory circuit means.

3. Apparatus as claimed in claim 2 characterised in that said gas chambers (27) open into a common supply chamber adapted for connection to a source of pressurised gas.

4. A memory system assembly characterised by comprising: an input interconnection network substrate (12) having a system input electrical connector pair first member affixed at a first edge portion thereof which can be selectively mated with a system input electrical connector pair second member for connection to external electrical apparatus to pass electrical signals therebetween, said input substrate first edge portion being located between input substrate second and third edge portions with said input substrate second edge portion having a first internal electrical connector pair first member affixed thereto and with said input substrate third edge portion having a second internal electrical connector pair first member affixed thereto, there being electrical interconnection provided between each of said first and second internal electrical connector pair first members and said system input electrical connector first pair member; an output interconnection network substrate (13) having a system output electrical connector pair first member affixed at a first edge portion thereof which can be selectively mated with a system output electrical connector pair second member for connection to external electrical apparatus to pass electrical signals therebetween, said output substrate first edge portion being located between output substrate second and third edge portions with said output substrate second edge portion having a third internal electrical connector pair first member affixed thereto and with said output substrate third edge portion having a fourth internal connector pair first member affixed thereto, there being electrical interconnections provided between each said third and fourth internal electrical connector pair first members and said system output electrical connector first member; a first transmission interconnection network substrate (15) having selected internal electrical connector pair second members affixed thereto including first and third internal electrical connector pair second members capable of being mechanically and electrically connected with said first and third internal electrical pair first members, respectively, there being electrical interconnections selectively provided between said plurality of internal electrical connector pair second members, said first and third internal electrical connector pair first members being mechanically and electrically connected with said first and third internal electrical connector pair second members, respectively; a second transmission interconnection network substrate (16) having selected internal electrical connector pair second members affixed thereto including second and fourth internal electrical connector pair second members capable of being mechanically and electrically connected with said second and fourth internal electrical pair first members, respectively, there being electrical interconnection selectively provided between said plurality of internal electrical connector pair second members, said second and fourth internal electrical connector pair first members being mechanically and electrically connected with said second and fourth internal electrical connector pair second members, respectively; and a plurality of memory module interconnection network substrates (14) each having a pair of internal electrical connector pair first members affixed at selected edges thereof one of which is capable of being, and is, mechanically and electrically connected with at least one of said selected internal electrical connector pair second members affixed to said first transmission interconnection network substrate (15) and that one remaining capable of being, and is, mechanically and electrically connected with at least one of said selected internal electrical connector pair second members affixed to said second transmission interconnection network substrate (16), each of said plurality of memory module interconnection network substrates (14) having at least one electronic memory circuit means affixed thereto with each said electronic memory circuit means having an electrical interconnection to each of said internal electrical connector pair first members affixed thereto; and a cooling insert means (11) positioned in at least some of those spaces occurring between members of said plurality of memory module interconnection network substrates (14) and between members of said plurality of memory module interconnection network substrates and said input and output interconnection network substrates (12,13), and having substantially enclosed gas chambers (27) located therein with openings (29) in said gas chambers opposite said electronic memory circuit means so that when a pressurised gas is supplied to said gas chambers that gas escaping from said openings therein will impinge on said electronic memory circuit means.

5. Apparatus as claimed in claim 4 characterised in that each of said gas chambers (27) opens into a common supply chamber adapted for connection to a source of pressurised gas.

6. Apparatus as claimed in any preceding claim characterised in that said electronic memory circuit means is a monolithic integrated circuit.

7. Apparatus as claimed in any preceding claim characterised in that each of said input and output interconnection network substrates (12,13) and each of said plurality of memory module interconnection network substrates (14) has a monolithic integrated circuit affixed thereto.

8. Apparatus as claimed in claim 6 or 7 characterised in that each of said monolithic integrated circuits is positioned in those spaces occurring between any pair of said memory module interconnection network substrates (14) and said input and output interconnection substrates (12,13).

9. Apparatus as claimed in any preceding claim characterised in that each of said input and output interconnection network substrates (12,13), said plurality of memory module interconnection network substrates (14), and said first and second transmission interconnection network substrates (15,16) are formed with a plurality of dielectric layers separating a plurality of interconnection network portions.

10. Apparatus as claimed in any preceding claim characterised in that at least one interconnection in said first transmission interconnection network substrate (15) is made commonly to each of said selected internal electrical connector pair second members affixed thereto.

11. Apparatus as claimed in any preceding claim characterised in that at least one interconnection in said second transmission interconnection network substrate (16) is made commonly to each of said selected internal electrical connector pair second members affixed thereto.

12. Apparatus as claimed in any preceding claim characterised in that said internal electrical connector pair first members are substantially identical to one another, and said internal electrical connector pair second members are substantially identical to one another.

13. Apparatus as claimed in any of claims 2 to 5 or any of claims 6 to 12 when dependent thereon characterised in that at least one of said plurality of memory module interconnection substrates (14) has a plurality of electronic memory circuit means affixed thereto in a column so that a gas chamber (27) on a said space adjacent such a memory module interconnection substrate (14) having a pair of linear protrusions (23) from its surface, has one of said linear protrusions on either side of said column.

14. Apparatus as claimed in any preceding claim characterised in that each of said plurality of memory module interconnection network substrates (14) is positioned between said input and output interconnection network substrates (12,13).

0276052    18·02·88

Fig.1

18·02·88

**Fig. 2**

**Fig. 3**

**Fig. 4**